# EUROPÄISCHE PATENTSCHRIFT

(11) **EP 2 603 618 B1**
(45) Veröffentlichungstag und Bekanntmachung des Hinweises auf die Patenterteilung: **26.11.2014**
(21) Anmeldenummer: 11712172.3
(22) Anmeldetag: 22.03.2011
(51) Int. Cl.: C23C 16/27, F16F 15/34

(54) **GLEITRING MIT VERBESSERTEN EINLAUFEIGENSCHAFTEN**
SLIP RING WITH IMPROVED RUN-IN PROPERTIES
BAGUE DE GLISSEMENT DE CARACTÉRISTIQUES DE RONDAGE AMÉLIORÉES

(30) Priorität: 09.08.2010 DE 202010011173 U
(43) Veröffentlichungstag der Anmeldung: 19.06.2013
(73) Patentinhaber: EagleBurgmann Germany GmbH & Co. KG, 82515 Wolfratshausen (DE); Fraunhofer-Gesellschaft zur Förderung der angewandten Forschung e.V., 80686 München (DE)
(72) Erfinder: SCHRÜFER, Andreas, 82515 Wolfratshausen (DE); THELKE, Jörg, 82515 Wolfratshausen (DE); RIEDL, Michael, 82335 Berg/Höhenrain (DE); SCHÄFER, Lothar, 38527 Meine (DE); ARMGARDT, Markus, 38100 Braunschweig (DE); HÖFER, Markus, 38162 Gardessen (DE)
(74) Vertreter: Schaeberle, Steffen
(86) Internationale Anmeldenummer: PCT/EP2011/001422
(87) Internationale Veröffentlichungsnummer: WO 2012/019658

(56) Entgegenhaltungen:
- EP-A2- 1 437 537
- DE-A1- 3 939 704
- DE-B3-102007 063 517
- DE-U1-202006 009 762
- DE-U1-202007 016 868

## Beschreibung

Die vorliegende Erfindung betrifft einen Gleitring bzw. eine Gleitringdichtung, welche eine Diamantbeschichtung aufweist und verbesserte Einlaufeigenschaften hat. Ferner betrifft die Erfindung ein Herstellungsverfahren für einen Gleitring.

Gleitringe und Gleitringdichtungen sind aus dem Stand der Technik in verschiedenen Ausgestaltungen bekannt. Hierbei müssen die Gleitringe während des Betriebes häufig sehr hohen Belastungen, insbesondere hohen Druck- und Temperaturbelastungen, standhalten. Hierzu wurde im Stand der Technik (DE 20 2007 016 868 U1) vorgeschlagen, einen Gleitring mit einem Basiskörper aus karbidischem Material mit einer Gleitfläche aus Diamantmaterial zu versehen. Es hat sich nun herausgestellt, dass bei Gleitringdichtungen mit diamantbeschichteten Gleitringen vor und während einer Inbetriebnahme aufgrund der mikrokristallinen Struktur der Diamantbeschichtung eine erhöhte Leckage im Vergleich mit Gleitringdichtungen ohne Diamantbeschichtungen auftreten kann. Aufgrund der möglichen Leckage kann somit vor der Inbetriebnahme und während des Einlaufzeitraums der Gleitringdichtung eine unerwünscht erhöhte Leckage auftreten, bis nach einer gewissen Betriebszeit die Spitzen der Diamantbeschichtung eingeschliffen sind und die Dichtheit gewährleistet ist. Insbesondere bei toxischen oder anderen umweltschädlichen Medien ist jedoch eine derartige anfängliche Leckage zu vermeiden. Ferner offenbart die gattungsemäße EP 1 437 537 A2 eine Gleitringdichtung, welche eine thermisch aufgespritzte Hartstoffschicht aufweist, die mit einem weiteren Gleitlack überzogen sein kann.

Es ist daher Aufgabe der vorliegenden Erfindung, einen diamantbeschichteten Gleitring und eine Gleitringdichtung mit diamantbeschichteten Gleitringen bereitzustellen, welche auch vor und während einer Einlaufphase eine sichere, leckagefreie Abdichtung gewährleistet.

Ferner ist es Aufgabe der vorliegenden Erfindung, ein Verfahren zur Herstellung eines diamantbeschichteten Gleitrings anzugeben, welcher insbesondere verbesserte Einlaufeigenschaften aufweist.

Diese Aufgabe wird durch einen Gleitring und eine Gleitringdichtung mit den Merkmalen des Anspruchs 1 bzw. 7 gelöst. Die Unteransprüche haben bevorzugte Weiterbildungen der Erfindung zum Gegenstand.

Der erfindungsgemäße Gleitring umfasst einen Basisbereich mit einer darauf aufgebrachten Diamantbeschichtung sowie eine auf die Diamantbeschichtung aufgebrachte Schmierstoffbeschichtung. Die Schmierstoffbeschichtung ist stoffschlüssig mit der Diamantbeschichtung verbunden und haftet auf der Oberfläche der Diamantbeschichtung. Insbesondere füllt die Schmierstoffbeschichtung Vertiefungen in der Diamantbeschichtung auf, so dass die mikrokristalline Struktur der Diamantbeschichtung durch die auffüllende Schmierstoffbeschichtung eine reduzierte Rauheit aufweist. Die zusätzliche Schmierstoffbeschichtung hat somit die Funktion einer Einlaufschicht und stellt eine höhere Dichtigkeit der Gleitringdichtung im Vergleich mit diamantbeschichteten Gleitringen ohne derartige Schmierstoffbeschichtung bereit.

Die Schmierstoffbeschichtung ist derart auf die Diamantbeschichtung aufgebracht, dass Spitzen der Diamantbeschichtung noch aus der Schmierstoffbeschichtung vorstehen. Die Schmierstoffbeschichtung füllt somit lediglich die Vertiefungen zwischen den Diamantspitzen teilweise aus. Dies hat den Vorteil, dass ein Verschleißwiderstand der Gleitflächen durch die hohe Härte der aus der Schmierstoffbeschichtung herausstehenden Diamantkristalle erhalten bleibt. Die Spitzen stehen dabei minimal aus der Schmierstoffbeschichtung vor. Vorzugsweise stehen die Spitzen in einem Bereich von 0 µm bis 8 µm, besonders bevorzugt 1 µm bis 6 µm, vor.

Die Schmierstoffbeschichtung umfasst vorzugsweise einen Trockenschmierstoff, einen Binder und gegebenenfalls flüchtige Komponenten. Als Trockenschmierstoff kann beispielsweise Graphit verwendet werden. Der Binder kann ein organischer oder ein anorganischer Binder sein. Besonders bevorzugt ist die Schmierstoffbeschichtung ein aufsprühbarer Gleitlack. Alternativ kann die Schmierstoffbeschichtung auch durch Tauchen oder Aufstreichen aufgebracht werden. Die Schmierstoffbeschichtung ist besonders bevorzugt hochtemperaturbeständig und weist einen Gebrauchstemperaturbereich von ungefähr -50°C bis +300°C auf.

Gemäß einer weiteren bevorzugten Ausgestaltung der vorliegenden Erfindung ist eine Dicke der Schmierstoffbeschichtung ungefähr gleich einer Dicke der Diamantbeschichtung. Hierdurch wird sichergestellt, dass die Schmierstoffbeschichtung zumindest bis zu den Spitzen der Diamantbeschichtung reicht, z.B. falls beispielsweise die Diamantbeschichtung eine Lücke auf dem Basisbereich aufweisen sollte und diese Lücke durch die Schmierstoffbeschichtung vom Basisbereich bis zur Spitze aufgefüllt wird. Wenn sichergestellt werden soll, dass Spitzen der Diamantbeschichtung aus der Schmierstoffbeschichtung vorstehen sollen, ist die Dicke der Schmierstoffbeschichtung vorzugsweise maximal die Hälfte der Dicke der Diamantbeschichtung.

Weiter bevorzugt überdeckt die Schmierstoffbeschichtung in radialer Richtung lediglich einen Teilbereich der Diamantbeschichtung in ringförmiger Weise. Hierdurch kann die notwendige Dichtheit durch die umlaufende Schmierstoffbeschichtung sichergestellt werden, ohne dass die gesamte Diamantbeschichtung mit der Schmierstoffbeschichtung überdeckt sein muss. Weiter kann bei dieser bevorzugten Ausgestaltung ein schnelleres Einlaufen der Gleitringe erreicht werden.

Weiterhin betrifft die vorliegende Erfindung eine Gleitringdichtung, umfassend wenigstens einen erfindungsgemäßen Gleitring. Besonders bevorzugt sind beide Gleitringe als erfindungsgemäße Gleitringe mit Diamantbeschichtung und zusätzlicher aufgebrachter Schmierstoffbeschichtung ausgebildet.

Die Erfindung betrifft ferner ein Verfahren zu Herstellung eines Gleitrings, umfassend die Schritte: Herstellen eines Basisbereichs, vorzugsweise aus Silizium-Carbid oder Wolfram-Carbid, Aufbringen einer Diamantbeschichtung auf eine Gleitseite des Basisbereichs und Aufbringen einer Schmierstoffbeschichtung auf die Diamantbeschichtung, wobei eine stoffschlüssige Verbindung zwischen der Schmierstoffbeschichtung und der Diamantbeschichtung hergestellt wird. Die Schmierstoffbeschichtung wird vorzugsweise in Form eines Gleitlacks aufgesprüht oder durch einen Tauchvorgang oder durch ein Aufstreichen auf die Diamantbeschichtung aufgebracht. Das erfindungsgemäße Verfahren umfasst ferner weiter bevorzugt einen Aushärteschritt, welcher mindestens 12 Std. dauert und bei Raumtemperatur ausgeführt wird. Weiter bevorzugt umfasst das erfindungsgemäße Verfahren einen anschließenden Polierschritt, bei dem die Schmierstoffbeschichtung bis zu den Diamantspitzen abgezogen wird, um eine möglichst ebene Gleitfläche mit geringer Rauheit bereitzustellen.

Erfindungsgemäß wird durch das Aufbringen der Schmierstoffbeschichtung somit nicht ein Reibverhalten der Gleitringdichtung verbessert, welches bei diamantbeschichteten Gleitringen von Haus aus sehr gut ist, sondern es wird eine Rauheit der Diamantbeschichtung eines unbenutzten (neuen) Gleitrings reduziert, um eine Stillstandsleckage und eine Anlaufleckage von neuen Gleitringen zu reduzieren bzw. zu vermeiden. Durch das Auffüllen der Vertiefung in der Diamantbeschichtung werden insbesondere Leckagewege verschlossen und so eine Leckage verhindert.

Der erfindungsgemäße Gleitring kann dabei sowohl bei flüssigkeitsgeschmierten Gleitringdichtungen als auch bei gasgeschmierten Gleitringdichtungen verwendet werden.

Nachfolgend werden unter Bezugnahme auf die begleitende Zeichnung bevorzugte Ausführungsbeispiele der Erfindung im Detail beschrieben. In der Zeichnung ist:
- Fig. 1: eine schematische Schnittansicht einer Gleitringdichtung gemäß einem ersten Ausführungsbeispiel der Erfindung,
- Fig. 2: eine Schnittansicht des stationären Gleitrings von Fig. 1, und
- Fig. 3: eine Schnittansicht eines Gleitrings gemäß einem zweiten Ausführungsbeispiel der Erfindung.

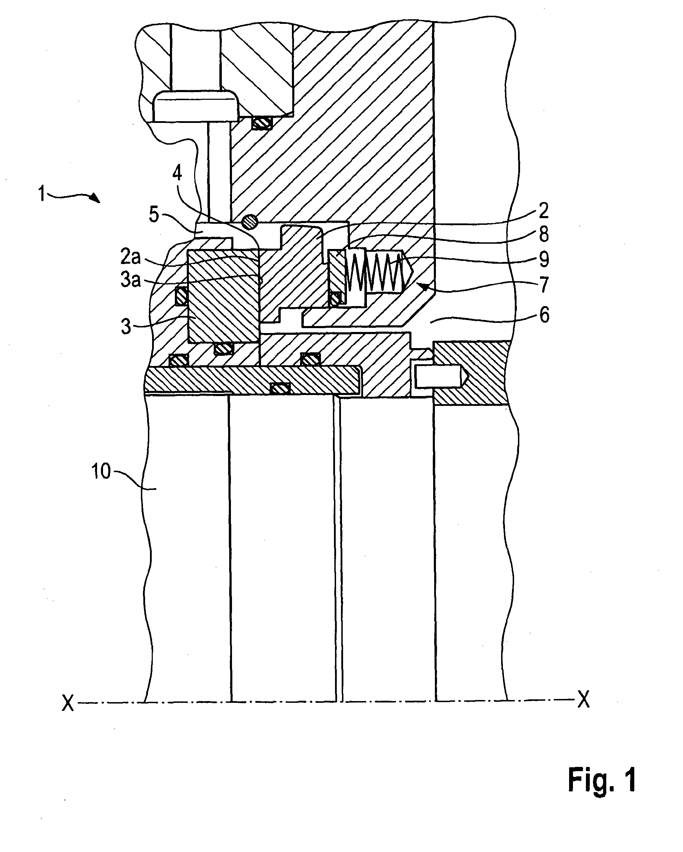

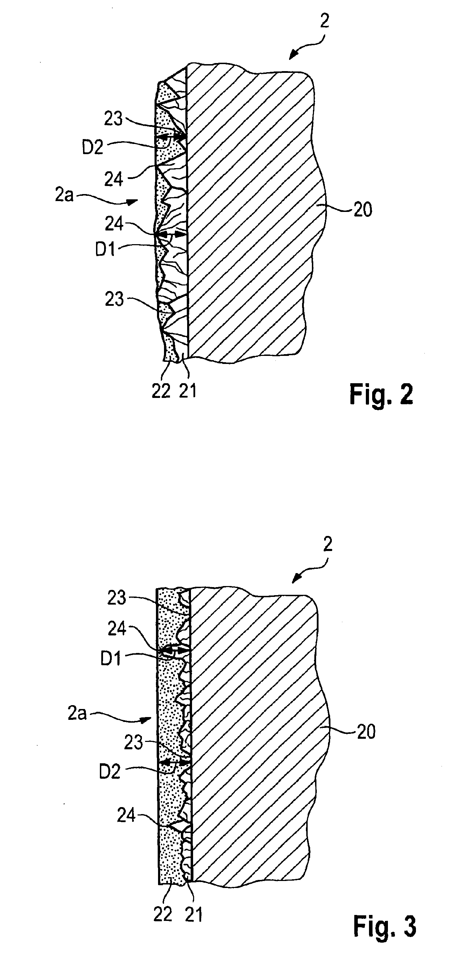

Nachfolgend wird unter Bezugnahme auf die Fig. 1 und 2 eine Gleitringdichtung 1 gemäß einem ersten bevorzugten Ausführungsbeispiel der Erfindung im Detail beschrieben.

Wie aus Fig. 1 ersichtlich ist, umfasst die Gleitringdichtung 1 einen stationären Gleitring 2 sowie einen rotierenden Gleitring 3. Der rotierende Gleitring 3 dreht sich gemeinsam mit einem rotierenden Bauteil 10, z.B. einer Welle. Die Gleitringe 2, 3 weisen einander gegenüberliegende Gleitflächen 2a und 3a auf, welche zwischen sich einen Dichtspalt 4 definieren. Die Gleitringdichtung 1 dichtet dabei zwischen einem ersten Raum 5 und einem zweiten Raum 6 an der rotierenden Welle 10 ab. Ferner umfasst die Gleitringdichtung 1 eine Vorspanneinrichtung 7 mit einem Kraftübertragungsring 8 und mehreren, entlang des Umfangs verteilten Vorspannfedern 9. Die Vorspanneinrichtung 7 spannt den stationären Gleitring 2 gegen den rotierenden Gleitring 3 vor. Mit X-X ist dabei eine Rotationsachse des rotierenden Bauteils 10 bezeichnet.

Fig. 2 zeigt eine vergrößerte Schnittdarstellung des stationären Gleitrings 2. Der stationäre Gleitring 2 umfasst einen Basisbereich 20, eine darauf aufgebrachte Diamantbeschichtung 21 sowie eine auf die Diamantbeschichtung 21 aufgebrachte Schmierstoffbeschichtung 22. Die Schmierstoffbeschichtung 22 ist stoffschlüssig mit der Diamantbeschichtung 21 verbunden und umfasst einen Trockenschmierstoff, wie z.B. Graphit. Die Schmierstoffbeschichtung 22 füllt dabei Vertiefungen 23 in der Diamantbeschichtung 21 auf. Beispielhaft sind in Fig. 2 zwei Vertiefungen 23 eingezeichnet. Das Bezugszeichen 24 bezeichnet beispielhaft zwei Spitzen der Diamantbeschichtung. Fig. 2 zeigt dabei einen neuwertigen Zustand des stationären Gleitrings 2, wobei in einem ersten Schritt die Diamantbeschichtung 21 auf dem Basisbereich 20 aufgebracht wird, dann die Schmiermittelbeschichtung 22 auf die Diamantbeschichtung 21 aufgebracht wird und anschließend die Schmiermittelbeschichtung bis zu den höchsten Spitzen 24 der Diamantbeschichtung abgezogen wird, so dass eine Gleitfläche 2a mit hoher Ebenheit erhalten wird, bei der die Vertiefungen 23 der Diamantbeschichtung vollständig mit der Schmierstoffbeschichtung 22 ausgefüllt sind.

Da die Vertiefungen 23 in der Diamantbeschichtung 21 zum Teil bis auf den Basisbereich 20 reichen können (in Fig. 2 beispielhaft an der oberen Vertiefung 23 dargestellt), ist eine maximale Dicke D1 der Diamantbeschichtung gleich einer maximalen Dicke D2 der Schmierstoffbeschichtung 22 im Bereich der größten Vertiefung 23. Die maximale Dicke D1 der Diamantbeschichtung reicht dabei vom Basisbereich 20 bis zum Ende der Spitze 24, welche unmittelbar an der Gleitfläche 2a endet.

Im ersten Ausführungsbeispiel sind beide Gleitringe 2, 3 gleich aufgebaut, so dass nach einer erfolgten Montage der Gleitringdichtung die beiden Gleitflächen 2a, 3a, bedingt durch die Vorspannung der Vorspanneinrichtung 7 dicht zueinander abschließen, so dass keine Leckage auftritt. Nach einigen Stunden oder Tagen eines Betriebes erfolgt ein teilweises Glätten der Spitzen 24 der Diamantbeschichtung 21, wobei auch etwas von der Schmierstoffbeschichtung 22 abgetragen wird, wodurch die Ebenheit der Gleitflächen 2a, 3a weiter verbessert wird.

Fig. 3 zeigt einen Gleitring 2 gemäß einem zweiten Ausführungsbeispiel der Erfindung, wobei gleiche bzw. funktional gleiche Teile mit den gleichen Bezugszeichen wie im ersten Ausführungsbeispiel bezeichnet sind. Das in Fig. 3 gezeigte Ausführungsbeispiel entspricht im Wesentlichen dem ersten Ausführungsbeispiel, wobei im Unterschied dazu die Spitzen 24 der Diamantbeschichtung 21 nicht aus der Schmierstoffbeschichtung 22 vorstehen und nicht bis zur Gleitfläche 2a reichen. Hierdurch ist eine Dicke D2 der Schmierstoffbeschichtung 22, welche im Bereich von sehr tiefen Vertiefungen 23 bis an den Basisbereich 20 reicht, größer als eine maximale Dicke D1 der Diamantbeschichtung 21 im Bereich der Spitzen 24. Hierdurch kann eine besonders ebene Gleitfläche mit geringer Rauigkeit erreicht werden. Nach einem gewissen Einlaufen der Gleitringdichtung wird die oberste Schmierstoffbeschichtung 22 abgerieben, so dass auch die Spitzen 24 der Diamantbeschichtung 21 an der Gleitfläche 2a liegen und die Verschleißfestigkeit der Gleitflächen der von ausschließlich mit diamantbeschichteten Gleitflächen entspricht.

### Bezugszeichenliste

- 1: Gleitringdichtung
- 2: stationärer Gleitring
- 3: rotierender Gleitring
- 2a, 3a: Gleitflächen
- 4: Dichtspalt
- 5: erster Raum
- 6: zweiter Raum
- 7: Vorspanneinrichtung
- 8: Kraftübertragungsring
- 9: Vorspannfedern
- 10: rotierendes Bauteil
- 20: Basisbereich
- 21: Diamantbeschichtung
- 22: Schmierstoffbeschichtung
- 23: Vertiefung
- 24: Spitze der Diamantbeschichtung
- D1: maximale Dicke der Diamantbeschichtung
- D2: maximale Dicke der Schmierstoffbeschichtung
- X-X: Rotationsachse des rotierenden Bauteils 10

## Patentansprüche

1. Gleitring, umfassend:
- einen Basisbereich (20),
- eine auf den Basisbereich (20) aufgebrachte Diamantbeschichtung (21), und
- eine auf die Diamantbeschichtung (21) aufgebrachte Schmierstoffbeschichtung (22), welche auf der Diamantbeschichtung haftet und Vertiefungen (23) der Diamantbeschichtung (21) auffüllt, wobei die Schmierstoffbeschichtung (22) derart auf der Diamantbeschichtung (21) aufgebracht ist, dass Spitzen (24) der Diamantbeschichtung (21) aus der Schmierstoffbeschichtung (22) vorstehen.

2. Gleitring nach Anspruch 1, **dadurch gekennzeichnet, dass** die Spitzen (24) in einem Bereich von 0 µm bis 8 µm, insbesondere 1 µ bis 6 µ, vorstehen.

3. Gleitring nach einem der vorhergehenden Ansprüche, **dadurch gekennzeichnet, dass** die Schmierstoffbeschichtung (22) einen Trockenschmierstoff, insbesondere Graphit, und einen Binder umfasst.

4. Gleitring nach einem der vorhergehenden Ansprüche, **dadurch gekennzeichnet, dass** eine Dicke (D2) der Schmierstoffbeschichtung (22) gleich einer Dicke (D1) der Diamantbeschichtung (21) ist.

5. Gleitring nach einem der vorhergehenden Ansprüche, **dadurch gekennzeichnet, dass** die Schmierstoffbeschichtung (22) in radialer Richtung nur einen Teilbereich der Diamantbeschichtung (21) ringförmig überdeckt.

6. Gleitringdichtung, umfassend einen oder zwei Gleitringe nach einem der vorhergehenden Ansprüche.

7. Verfahren zur Herstellung eines Gleitrings, umfassend die Schritte:
- Herstellen eines Basisbereiches, vorzugsweise aus Silizium-Carbid oder Wolfram-Carbid,
- Aufbringen einer Diamantbeschichtung auf eine Gleitseite des Basisbereichs und
- Aufbringen einer Schmierstoffbeschichtung auf die Diamantbeschichtung, wobei eine stoffschlüssige Verbindung zwischen der Schmierstoffbeschichtung und der Diamantbeschichtung hergestellt wird,
- wobei die Schmierstoffbeschichtung derart auf die Diamantbeschichtung aufgebracht wird, dass Spitzen der Diamantbeschichtung aus der Schmierstoffbeschichtung vorstehen.

8. Verfahren nach Anspruch 7, **dadurch gekennzeichnet, dass** die Schmierstoffbeschichtung aufgesprüht oder durch einen Tauchvorgang oder durch ein Aufstreichen auf die Diamantbeschichtung aufgebracht wird.

9. Verfahren nach Anspruch 7 oder 8, **dadurch gekennzeichnet, dass** die Schmierstoffbeschichtung ein Gleitlack ist.

## Claims

1. Slip ring comprising:
- a base region (20),
- a diamond coating (21) deposited on the base region (20), and
- a lubricant coating (22) deposited on the diamond coating (21) which adheres to the diamond coating and fills recesses (23) of the diamond coating (21), wherein said lubricant coating (22) is applied on the diamond coating (21) in such a way that tips (24) of the diamond coating (21) of the lubricant coating (22) protrude.

2. The slip ring according to claim 1, **characterized in that** the tips (24) project in a range from 0 µm to 8 µm, particularly 1 µm to 6 µm.

3. The slip ring according to any one of the preceding claims, **characterized in that** said the lubricant coating (22) comprises a dry lubricant, in particular graphite, and a binder.

4. The slip ring according to any one of the preceding claims, **characterized in that** a thickness (D2) of the lubricant coating (22) is equal to a thickness (D1) of the diamond coating (21).

5. The slip ring according to any one of the preceding claims, **characterized in that** said lubricant coating (22) overlaps only a portion of the diamond coating (21) in the radial direction annularly.

6. The slip ring sealing, comprising one or two slip rings according to one of the preceding claims.

7. A method for producing a slip ring, comprising the steps of:
- forming a base region, preferably of silicon carbide or tungsten carbide,
- applying a diamond coating on a sliding face of the base portion and
- applying a lubricant coating to the diamond coating, producing a material bonded connection between the lubricant coating and the coating diamond,
- wherein the lubricant coating is applied to the diamond coating in a way that the tips of the diamond coating protrude from the lubricant coating.

8. The method according to claim 7, **characterized in that** the lubricant coating is sprayed on or applied by a dipping process or a spreading on the diamond coating.

9. The method according to claim 7 or 8, **characterized in that** the lubricant coating is a sliding lacquer.

## Revendications

1. Bague de glissement comprenant :
- une région de base (20),
- un revêtement en diamant (21) déposé sur ladite région de base (20), et
- un revêtement lubrifiant (22) déposé sur ledit revêtement en diamant (21), qui adhère audit revêtement en diamant et comble des anfractuosités (23) dudit revêtement en diamant (21), ledit revêtement lubrifiant (22) étant déposé, sur ledit revêtement en diamant (21), de façon telle que des pointes (24) dudit revêtement en diamant (21) fassent saillie au-delà dudit revêtement lubrifiant (22).

2. Bague de glissement selon la revendication 1, **caractérisée par le fait que** les pointes (24) font saillie dans une plage de 0 µm à 8 µm, notamment de 1 µ à 6 µ.

3. Bague de glissement selon l'une des revendications précédentes, **caractérisée par le fait que** le revêtement lubrifiant (22) renferme un liant et une substance lubrifiante sèche, en particulier du graphite.

4. Bague de glissement selon l'une des revendications précédentes, **caractérisée par le fait qu'**une épaisseur (D2) du revêtement lubrifiant (22) est égale à une épaisseur (D1) du revêtement en diamant (21).

5. Bague de glissement selon l'une des revendications précédentes, **caractérisée par le fait que** le revêtement lubrifiant (22) ne recouvre annulairement, dans le sens radial, qu'une région partielle du revêtement en diamant (21).

6. Garniture d'étanchement à bague(s) de glissement, comprenant une ou deux bague(s) de glissement conforme(s) à l'une des revendications précédentes.

7. Procédé de fabrication d'une bague de glissement, incluant les étapes consistant à :
- produire une région de base, de préférence en carbure de silicium ou en carbure de tungstène,
- déposer un revêtement en diamant sur une face de glissement de ladite région de base et
- déposer un revêtement lubrifiant sur ledit revêtement en diamant, une solidarisation matérielle étant alors instaurée entre ledit revêtement lubrifiant et ledit revêtement en diamant,
- ledit revêtement lubrifiant étant déposé, sur ledit revêtement en diamant, de façon telle que des pointes dudit revêtement en diamant fassent saillie au-delà dudit revêtement lubrifiant.

8. Procédé selon la revendication 7, **caractérisé par le fait que** le revêtement lubrifiant est appliqué par pulvérisation, ou est déposé sur le revêtement en diamant par un processus d'immersion, ou par enduction.

9. Procédé selon la revendication 7 ou 8, **caractérisé par le fait que** le revêtement lubrifiant est un vernis de glissement.
